# EUROPEAN PATENT APPLICATION

(11) **EP 4 415 490 A1**
(43) Date of publication of application: **14.08.2024**
(21) Application number: 21959971.9
(22) Date of filing: 08.10.2021
(51) Int. Cl.: H05K 3/10

(54) **CIRCUIT FORMING METHOD AND INFORMATION PROCESSING DEVICE**

(71) Applicant: Fuji Corporation, Chiryu-shi, Aichi 472-8686 (JP)
(72) Inventor: TOMINAGA, Ryojiro, Chiryu-shi, Aichi 472-8686 (JP)
(74) Representative: Grünecker Patent- und Rechtsanwälte PartG mbB
(86) International application number: PCT/JP2021/037372
(87) International publication number: WO 2023/058230

(57) **Abstract**

A circuit forming method including: an acquiring step of acquiring metal-containing liquid information including at least one of a density of a metal-containing liquid containing metal fine particles or a content of the metal fine particles; a calculating step of calculating the number of layers of the metal-containing liquid required to form a wiring by stacking the metal-containing liquid, based on the metal-containing liquid information acquired in the acquiring step; and a wiring forming step of forming a wiring by stacking the metal-containing liquid in the number of layers calculated in the calculating step.

## Description

### Technical Field

The present invention relates to a circuit forming method for forming a wiring using a metal-containing liquid containing metal fine particles.

### Background Art

The following patent literature describes a technique of forming a wiring using a metal-containing liquid containing metal fine particles.

### Patent Literature

Patent Literature 1: JP-A-2014-144417

### Summary of the Invention

### Technical Problem

When the wiring is formed using the metal-containing liquid containing the metal fine particles, the metal-containing liquid is stacked to form the wiring. Accordingly, an object of the present description is to form a wiring by stacking a metal-containing liquid in an appropriate number of layers.

### Solution to Problem

In order to solve the above problem, the present description discloses a circuit forming method including: an acquiring step of acquiring metal-containing liquid information including at least one of a density of a metal-containing liquid containing metal fine particles or a content of the metal fine particles; a calculating step of calculating the number of layers of the metal-containing liquid required to form a wiring by stacking the metal-containing liquid, based on the metal-containing liquid information acquired in the acquiring step; and a wiring forming step of forming a wiring by stacking the metal-containing liquid in the number of layers calculated in the calculating step.

In addition, the present description discloses an information processing device including: an acquisition section configured to acquire metal-containing liquid information including at least one of a density of a metal-containing liquid containing metal fine particles or a content of the metal fine particles; and a calculating section configured to calculate the number of layers of the metal-containing liquid required to form a wiring by stacking the metal-containing liquid, based on the metal-containing liquid information acquired by the acquisition section.

### Advantageous Effect of the Invention

In the present disclosure, based on the metal-containing liquid information including at least one of the density of the metal-containing liquid or the content of the metal fine particles, the number of layers of the metal-containing liquid required to form the wiring by stacking the metal-containing liquid is calculated. Accordingly, the metal-containing liquid can be stacked in an appropriate number of layers to form the wiring.

### Brief Description of Drawings

Fig. 1 is a diagram illustrating a circuit forming device.
Fig. 2 is a block diagram illustrating a control device.
Fig. 3 is a cross-sectional view illustrating a circuit in a state where a resin stack is formed.
Fig. 4 is a cross-sectional view illustrating a circuit in a state where a wiring is formed on the resin stack.
Fig. 5 is map data illustrating the relationship between the number of layers of metal ink and the content of metal fine particles in the metal ink.

### Description of Embodiments

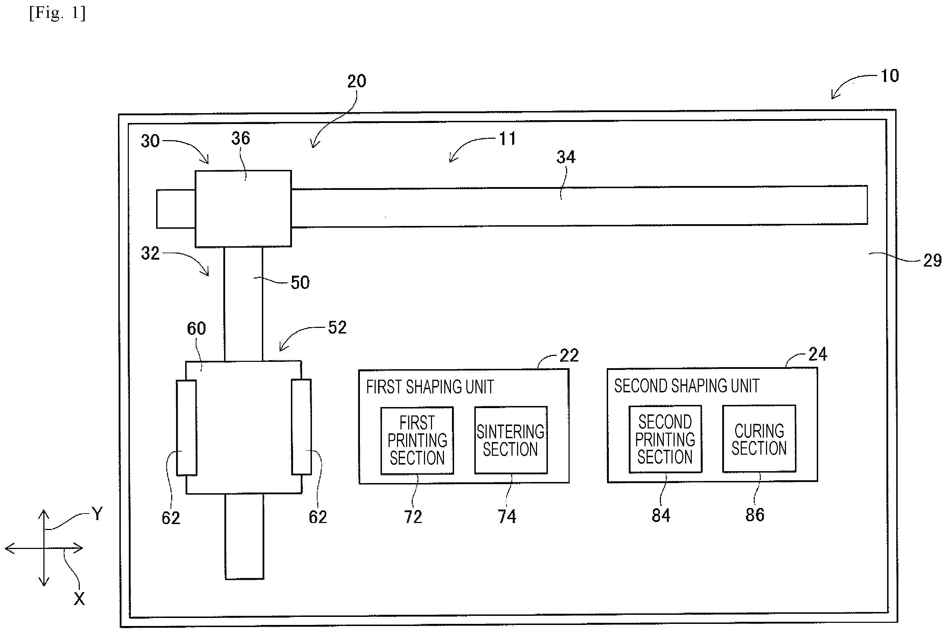

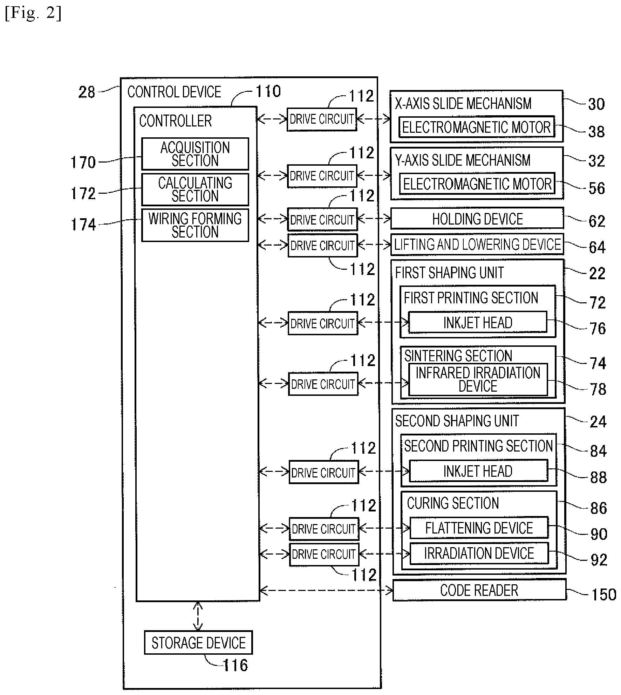

Fig. 1 illustrates circuit forming device 10. Circuit forming device 10 is provided with conveyance device 20, first shaping unit 22, second shaping unit 24, and control device 28 (refer to Fig. 2). Conveyance device 20, first shaping unit 22, and second shaping unit 24 are disposed on base 29 of circuit forming device 10. Base 29 has a generally rectangular shape, and in the following description, a longer direction of base 29 will be referred to as an X-axis direction, a shorter direction of base 29 will be referred to as a Y-axis direction, and a direction orthogonal to both the X-axis direction and the Y-axis direction will be referred to as a Z-axis direction. The Z-axis direction is the same as the vertical direction.

Conveyance device 20 is provided with X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. X-axis slide mechanism 30 further includes electromagnetic motor 38 (refer to Fig. 2), and X-axis slider 36 is moved to any position in the X-axis direction by driving electromagnetic motor 38. In addition, Y-axis slide mechanism 32 includes Y-axis slide rail 50 and table 52. Y-axis slide rail 50 is disposed on base 29 to extend in the Y-axis direction and is movable in the X-axis direction. One end portion of Y-axis slide rail 50 is coupled to X-axis slider 36. Table 52 is held on Y-axis slide rail 50 to be slidable in the Y-axis direction. Furthermore, Y-axis slide mechanism 32 includes electromagnetic motor 56 (refer to Fig. 2), and table 52 is moved to any position in the Y-axis direction by driving electromagnetic motor 56. In this manner, table 52 is moved to any position on base 29 by driving X-axis slide mechanism 30 and Y-axis slide mechanism 32.

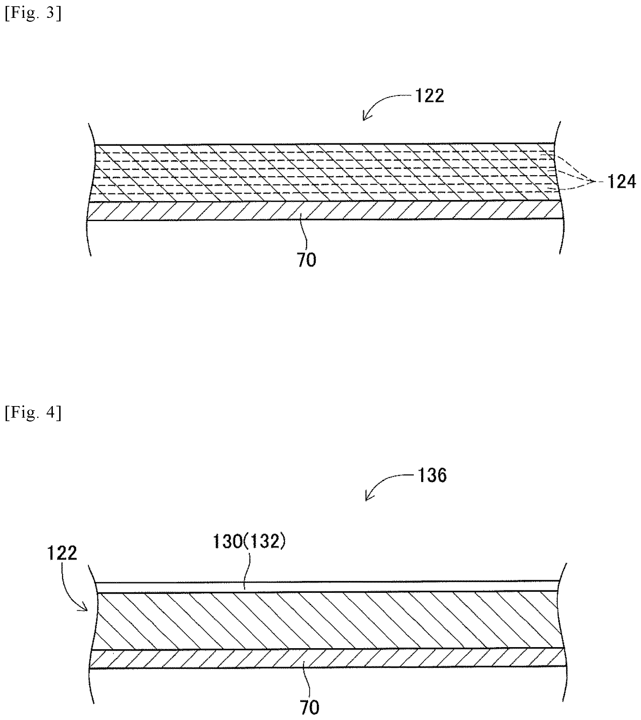

Table 52 includes base plate 60, holding device 62, and lifting and lowering device 64 (refer to Fig. 2). Base plate 60 is formed in a flat plate shape, and pallet 70 (refer to Fig. 3) is placed on an upper surface thereof. Holding devices 62 are provided on both side portions of base plate 60 in the X-axis direction. Then, both edge portions of pallet 70 placed on base plate 60 in the X-axis direction are sandwiched by holding devices 62, so that pallet 70 is fixedly held. In addition, lifting and lowering device 64 is disposed below base plate 60, and lifts and lowers base plate 60.

First shaping unit 22 is a unit that shapes a wiring of a circuit board, and includes first printing section 72 and sintering section 74. First printing section 72 includes inkjet head 76 (refer to Fig. 2), and inkjet head 76 linearly discharges metal ink. The metal ink is ink obtained by dispersing nanometer-sized metal, for example, silver fine particles in a solvent. Surfaces of the metal fine particles are coated with a dispersant and aggregation in the solvent is prevented. In addition, inkjet head 76 discharges the metal ink from multiple nozzles by, for example, a piezo method using a piezoelectric element.

Sintering section 74 includes infrared irradiation device 78 (refer to Fig. 2). Infrared irradiation device 78 is a device for irradiating the discharged metal ink with infrared light, and the metal ink irradiated with infrared light is sintered to form the wiring. Sintering of the metal ink is, for example, a phenomenon in which evaporation of a solvent or decomposition of a protective film of metal fine particles, that is, a dispersant is performed by applying energy, so that conductivity is increased by contacting or fusing the metal fine particles. Then, the metal ink is sintered to form a metal wiring.

In addition, second shaping unit 24 is a unit that shapes a resin layer of a circuit board, and includes second printing section 84 and curing section 86. Second printing section 84 includes inkjet head 88 (refer to Fig. 2), and inkjet head 88 discharges an ultraviolet curable resin. The ultraviolet curable resin is a resin that is cured by irradiation with ultraviolet light. Inkjet head 88 may be, for example, a piezo type inkjet head using a piezoelectric element, or may be a thermal type inkjet head in which a resin is heated to generate air bubbles, which are discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and makes the thickness of the ultraviolet curable resin uniform, for example, by scraping off excess resin by a roller or a blade while leveling the surface of the ultraviolet curable resin. In addition, irradiation device 92 includes a mercury lamp or LED as a light source, and irradiates the discharged ultraviolet curable resin with ultraviolet light. As a result, the discharged ultraviolet curable resin is cured to form the resin layer.

As illustrated in Fig. 2, control device 28 includes controller 110, multiple drive circuits 112, and storage device 116. Multiple drive circuits 112 are connected to electromagnetic motors 38 and 56, holding device 62, lifting and lowering device 64, inkjet head 76, infrared irradiation device 78, inkjet head 88, flattening device 90, and irradiation device 92. Controller 110 includes CPU, ROM, RAM, and the like, is mainly a computer, and is connected to multiple drive circuits 112. As a result, the operations of conveyance device 20, first shaping unit 22, and second shaping unit 24 are controlled by controller 110. Controller 110 is also connected to storage device 116 and acquires various data stored in storage device 116 from storage device 116.

In circuit forming device 10, with the above-described configuration, a resin stack is formed on pallet 70 placed on base plate 60 of table 52, and a wiring is formed on the upper surface of the resin stack and thus a circuit board is formed.

Specifically, when pallet 70 is set on base plate 60 of table 52, table 52 is moved to a position below second shaping unit 24. In second shaping unit 24, as illustrated in Fig. 3, resin stack 122 is formed on pallet 70. Resin stack 122 is formed by repeating the discharge of the ultraviolet curable resin from inkjet head 88 and the irradiation with ultraviolet light by irradiation device 92 to the discharged ultraviolet curable resin.

More specifically, in second printing section 84 of second shaping unit 24, inkjet head 88 discharges the ultraviolet curable resin in a thin film shape on the upper surface of pallet 70. Subsequently, when the ultraviolet curable resin is discharged in the thin film shape, the ultraviolet curable resin is flattened by flattening device 90 in curing section 86 so that the ultraviolet curable resin has a uniform film thickness. Irradiation device 92 irradiates the thin film-shaped ultraviolet curable resin with ultraviolet light. As a result, thin film-shaped resin layer 124 is formed on pallet 70.

Subsequently, inkjet head 88 discharges the ultraviolet curable resin in a thin film shape onto thin film-shaped resin layer 124. The thin film-shaped ultraviolet curable resin is flattened by flattening device 90, irradiation device 92 irradiates the ultraviolet curable resin discharged in a thin film shape with ultraviolet light, and thus thin film-shaped resin layer 124 is stacked on thin film-shaped resin layer 124. As described above, the discharge of the ultraviolet curable resin on thin film-shaped resin layer 124 and the irradiation with the ultraviolet light are repeated, and multiple resin layers 124 are stacked and thus resin stack 122 is formed.

Next, when resin stack 122 is formed, table 52 moves to a position below first shaping unit 22. In first printing section 72 of first shaping unit 22, as illustrated in Fig. 4, inkjet head 76 linearly discharges metal ink 130 on the upper surface of resin stack 122 in accordance with the circuit pattern. Subsequently, infrared irradiation device 78 irradiates metal ink 130 discharged in accordance with the circuit pattern with infrared light in sintering section 74 of first shaping unit 22. As a result, metal ink 130 is sintered, and wiring 132 is formed on the upper surface of resin stack 122.

In this manner, resin stack 122 is formed on pallet 70 in second shaping unit 24, and wiring 132 is formed on resin stack 122 in first shaping unit 22, and thus circuit board 136 is formed. Wiring 132 formed on resin stack 122 is formed by stacking metal ink 130. Specifically, the first layer of metal ink 130 is discharged onto the upper surface of resin stack 122, and the first layer of metal ink 130 is irradiated with the infrared light. As a result, the first layer of metal ink 130 is sintered to form the first layer of a metal thin film. Next, the second layer of metal ink 130 is discharged onto the first layer of the metal thin film, and the second layer of metal ink 130 is irradiated with the infrared light. As a result, the second layer of metal ink 130 is sintered to form the second layer of a metal thin film. In this way, by repeating the discharge of metal ink 130 and the irradiation with the infrared light, the metal thin film is stacked, and wiring 132 having a predetermined thickness is formed.

However, the content of the metal fine particles in metal ink 130 is different for each lot. This is because, at the metal ink supplier, filtering of the metal ink is performed when the metal ink is manufactured. Specifically, as described above, the metal ink is ink obtained by dispersing metal fine particles in a solvent, and the metal fine particles are sintered by irradiation with infrared light, whereby the conductivity increases and a wiring is formed. Therefore, in order to stabilize the sintering temperature, it is necessary to make the particle diameter of the metal fine particles uniform. At the metal ink supplier, filtering of the metal ink is performed when manufacturing the metal ink. However, since the amount of the metal fine particles trapped by the filter varies depending on the manufacturing condition, the content of the filtered metal fine particles of metal ink 130 varies for each lot. That is, in the metal ink in which more metal fine particles are trapped by the filter, the content of the metal fine particles is small, and in the metal ink in which the metal fine particles are not trapped to a significant extent by the filter, the content of the metal fine particles is large.

As described above, when the content of the metal fine particles in metal ink 130 is different for each lot, the thickness of the wiring becomes either thicker or thinner than the predetermined thickness in accordance with the content of the metal fine particles, even when attempting to form a wiring having the predetermined thickness. Specifically, in the conventional circuit forming device, the number of layers N of the metal ink required to form the wiring having the predetermined thickness L is set based on the reference content of the metal fine particles (hereinafter referred to as "reference content"). The number of layers of the metal ink is the number of times of repetition of discharge of the metal ink and irradiation with the infrared light, and is the number of layers of the metal thin film formed by discharge of the metal ink and irradiation with the infrared light.

Therefore, N layers of the metal ink of the reference content are stacked to form a wiring and thus the wiring having a predetermined thickness L is formed. However, when the wiring is formed by stacking N layers of the metal ink having a content less than the reference content, the wiring having a thickness smaller than the predetermined thickness L is formed. In addition, when the wiring is formed by stacking N layers of the metal ink having a content larger than the reference content, the wiring having a thickness greater than the predetermined thickness L is formed. In this way, when the thickness of the wiring becomes thicker or thinner than the predetermined thickness, the electrical resistance value of the circuit will not be constant, and there is a possibility that the circuit cannot be appropriately formed.

In view of this, in circuit forming device 10, the wiring is formed by changing the number of layers of the metal ink in accordance with the content of the metal fine particles in the metal ink. Specifically, at the metal ink supplier, ink information such as the content of metal fine particles, the density of the metal ink, and the surface tension of the metal ink is measured as an inspection before shipment of the metal ink. The ink information and the lot number of the metal ink are coded in association with each other, and the coded two-dimensional barcode is attached to the container of the metal ink. The two-dimensional barcode may be attached to a bottle filled with metal ink, or may be attached to a box or the like that accommodates the bottle.

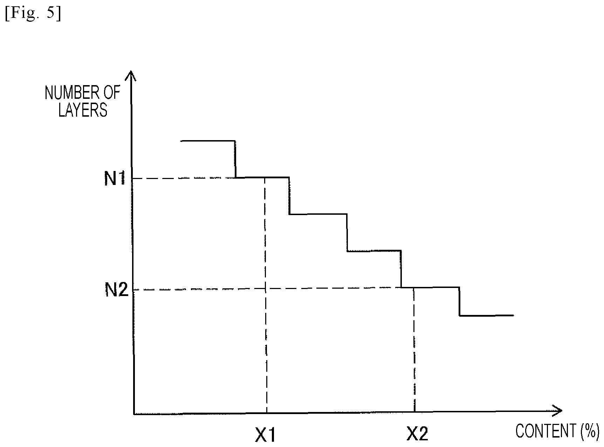

Circuit forming device 10 is provided with code reader 150 (refer to Fig. 2), and code reader 150 is connected to controller 110. Therefore, the operator reads the two-dimensional barcode attached to the container of the metal ink using code reader 150 before forming the circuit, whereby controller 110 acquires the content of the metal fine particles in the metal ink and the lot number of the metal ink. Storage device 116 stores map data illustrated in Fig. 5. This map data indicates a correspondence relationship between the number of layers of the metal ink and the content of the metal fine particles, and the number of layers of the metal ink required to form the wiring having the predetermined thickness L is set for each content of the metal fine particles. In the map data, the number of layers of the metal ink is set to be larger as the content of the metal fine particles is smaller, and the number of layers of the metal ink is set to be smaller as the content of the metal fine particles is larger.

When the content of the metal fine particles is acquired from the two-dimensional barcode, controller 110 refers to the map data stored in storage device 116 and calculates the number of layers of the metal ink in accordance with the acquired content of the metal fine particles. Specifically, for example, controller 110 calculates the number of layers N1 of the metal ink when the content of the metal fine particles acquired from the two-dimensional barcode is X1, and calculates the number of layers N2 of the metal ink when the content of the metal fine particles acquired from the two-dimensional barcode is X2. When the number of layers of the metal ink is calculated, controller 110 stores information in which the calculated number of layers of the metal ink is associated with the lot number of the metal ink acquired from the two-dimensional barcode (hereinafter, referred to as "lot information") in storage device 116.

As described above, when controller 110 stores the lot information in storage device 116, controller 110 forms a wiring based on the lot information when forming the circuit. Specifically, when forming the wiring, the lot number of the metal ink used for forming the wiring is input to controller 110. Controller 110 refers to the lot information and specifies the number of layers N of the metal ink associated with the input lot number. Then, when forming the wiring, controller 110 forms the wiring by stacking the metal ink with the specified number of layers N. That is, controller 110 repeats the discharge of the metal ink and the irradiation with the infrared light N times to stack N layers of the metal thin films and thus the wiring is formed.

As described above, by specifying the number of layers of the metal ink in accordance with the content of the metal fine particles in the metal ink and forming the wiring by stacking the metal ink by the specified number of layers, it is possible to make the thickness of the wiring constant regardless of the content of the metal fine particles. Accordingly, it is possible to make the electrical resistance value of the circuit constant, so that the circuit can be appropriately formed. Furthermore, since the thickness of the wiring can be made constant regardless of the content of the metal fine particles, variations in the content of the metal fine particles can be allowed. As a result, it is possible to increase the manufacturing yield of the metal ink at the metal ink supplier. That is, in the quality control of the metal ink at the metal ink supplier, when the allowable range of the content of the metal fine particles is, for example, ±10% of the reference content, the allowable range of the content of the metal fine particles can be expanded to ±20% of the reference content. In this way, by expanding the allowable range of the content of the metal fine particles, it is possible to increase the manufacturing yield of the metal ink. By increasing the manufacturing yield of the metal ink, it is possible to reduce the manufacturing cost of the metal ink. This makes it possible to also reduce the cost required to form the circuit.

As illustrated in Fig. 2, controller 110 of control device 28 includes acquisition section 170, calculating section 172, and wiring forming section 174. Acquisition section 170 is a functional section for acquiring the content of the metal fine particles in the metal ink included in the ink information by reading the ink information from the two-dimensional barcode. Calculating section 172 is a functional section for calculating the number of layers of the metal ink based on the content of the metal fine particles acquired by acquisition section 170. Wiring forming section 174 is a functional section for forming a wiring by stacking the metal ink in the number of layers of the metal ink calculated by calculating section 172.

In the above example, control device 28 is an example of an information processing device. Storage device 116 is an example of a memory. Metal ink 130 is an example of a metal-containing liquid. Wiring 132 is an example of a wiring. Code reader 150 is an example of a reading device. Acquisition section 170 is an example of an acquisition section. Calculating section 172 is an example of a calculating section. A step performed by acquisition section 170 is an example of an acquiring step. A step performed by calculating section 172 is an example of a calculating step. A step performed by wiring forming section 174 is an example of a wiring forming step.

The present invention is not limited to the example described above, and can be performed in various aspects to which various modifications and improvements are applied based on the knowledge of those skilled in the art. For example, in the above-described example, the number of layers of the metal ink is calculated based on the content of the metal fine particles included in the ink information; however, the number of layers of the metal ink may be calculated based on the density of the metal ink included in the ink information. The number of layers of the metal ink may be calculated based on both the content of the metal fine particles and the density of the metal ink. That is, the number of layers of the metal ink may be calculated based on at least one of the content of the metal fine particles or the density of the metal ink. Furthermore, the number of layers of the metal ink may be calculated based on at least one of the content of the metal fine particles or the density of the metal ink, and the surface tension of the metal ink and the like.

In the above-described example, in controller 110 of control device 28, the ink information is acquired and the number of layers of the metal ink is calculated based on the ink information, thereby controlling the operation of first shaping unit 22 such that the metal ink is stacked in the calculated number of layers. Alternatively, in an information processing device different from control device 28, ink information may be acquired, and the number of layers of the metal ink may be calculated based on the ink information. Then, the number of layers calculated by the information processing device may be input to control device 28, and control device 28 may control the operation of first shaping unit 22 to stack the metal ink in the input number of layers. That is, the information processing device may include acquisition section 170 and calculating section 172, and controller 110 of control device 28 may include wiring forming section 174.

In the above-described example, the ink information is acquired from the two-dimensional barcode, that is, the identification code in which the ink information is coded, but the ink information may be acquired from a memory, a server, or the like.

In the above-described example, the ink information is automatically acquired by reading the two-dimensional barcode with code reader 150; however, the operator may manually input the ink information into control device 28.

Further, in the above-described example, the metal ink for forming a wiring is adopted as the metal-containing liquid, but various metal-containing liquids can be adopted as long as the metal-containing liquid contains the metal fine particles. Specifically, for example, a conductive paste in which metal fine particles having a micrometer size are dispersed in a solvent can be adopted as the metal-containing liquid.

### Reference Signs List

28: control device (information processing device), 116: storage device (memory), 130: metal ink (metal-containing liquid), 132: wiring, 150: code reader (reading device), 170: acquisition section (acquiring step), 172: calculating section (calculating step), 174: wiring forming section (wiring forming step).

## Claims

1. A circuit forming method comprising:
an acquiring step of acquiring metal-containing liquid information including at least one of a density of a metal-containing liquid containing metal fine particles or a content of the metal fine particles;
a calculating step of calculating the number of layers of the metal-containing liquid required to form a wiring by stacking the metal-containing liquid, based on the metal-containing liquid information acquired in the acquiring step; and
a wiring forming step of forming a wiring by stacking the metal-containing liquid in the number of layers calculated in the calculating step.

2. The circuit forming method according to claim 1, wherein
in the calculating step, information stored in a memory, indicating a correspondence relationship between the metal-containing liquid information and the number of layers of the metal-containing liquid, is used to calculate the number of layers of the metal-containing liquid, based on the metal-containing liquid information acquired in the acquiring step.

3. The circuit forming method according to claim 1 or 2, wherein
in the acquiring step, the metal-containing liquid information is acquired by reading an identification code, in which the metal-containing liquid information is coded, by a reading device.

4. The circuit forming method according to claim 3, wherein
in the acquiring step, the metal-containing liquid information is acquired by reading the identification code provided on a container of the metal-containing liquid, by the reading device.

5. An information processing device comprising:
an acquisition section configured to acquire metal-containing liquid information including at least one of a density of a metal-containing liquid containing metal fine particles or a content of the metal fine particles; and
a calculating section configured to calculate the number of layers of the metal-containing liquid required to form a wiring by stacking the metal-containing liquid, based on the metal-containing liquid information acquired by the acquisition section.
